# EUROPEAN PATENT SPECIFICATION

(11) **EP 0 854 517 B1**
(45) Date of publication and mention of the grant of the patent: **12.02.2003**
(21) Application number: 98200590.2
(22) Date of filing: 26.11.1991
(51) Int. Cl.: H01L 27/148

(54) **A solid-state imaging device**
Festkörper-Bildaufnahmevorrichtung
Dispositif d'imagerie à l'état solide

(30) Priority: 29.11.1990 JP 33625790
(43) Date of publication of application: 22.07.1998
(62) Divisional of application: 91310878.3
(73) Proprietor: NATIONAL SPACE DEVELOPMENT AGENCY OF JAPAN, Minato-ku Tokyo (JP); MITSUBISHI DENKI KABUSHIKI KAISHA, Tokyo (JP)
(72) Inventor: Masuda, Takeshi, c/o National Space Development, Minato-ku, Tokyo (JP); Yashiro, Kiyotaka, c/o National Space Development, Minato-ku, Tokyo (JP); Tange, Yoshio, c/o National Space Development, Minato-ku, Tokyo (JP); Miyachi, Yuji, c/o National Space Development, Minato-ku, Tokyo (JP); Shiraishi, Tadashi, c/o Mitsubishi Denki K.K., Itami-shi, Hyogo-ken (JP)
(74) Representative: Beresford, Keith Denis Lewis

(56) References cited:
- US-A- 3 890 633
- US-A- 4 647 977
- PATENT ABSTRACTS OF JAPAN vol. 007, no. 239 (E-206), 25 October 1983 & JP 58 130564 A (TOKYO SHIBAURA DENKI KK), 4 August 1983

## Description

The present invention relates to a solid-state imaging device and, more particularly, to the structure of a charge input means of a charge coupled device (hereinafter referred to as CCD).

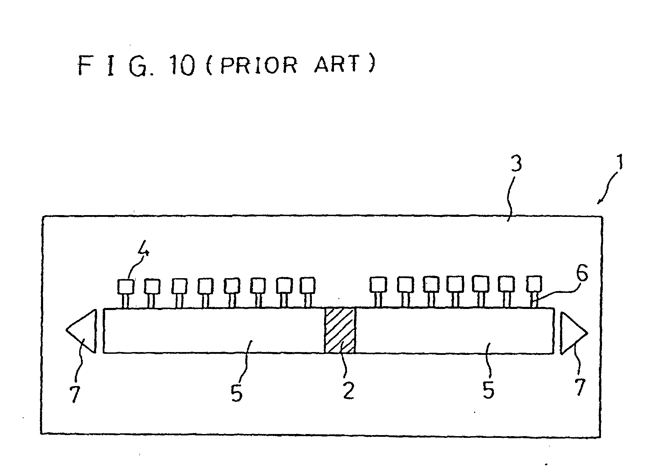

In linear image sensors, signal charges generated in a plurality of light receiving elements arranged on a one-dimensional array are read out by one CCD. Recently, needs for higher resolution have been increased and the number of light receiving elements has been increased. However, if the number of light receiving elements is increased, the number of stages of the CCD must also be increased, resulting in a deterioration in overall transfer efficiency, a high-speed data rate or the like. In order to solve these problems, a solid-state imaging device shown in figure 10, in which light receiving elements are divided in the middle and signal charges are read out by two CCDs arranged in series, has been proposed.

In figure 10, which depicts an unpublished prior art device, a plurality of photodiodes (light receiving elements) 4 constituting a light-to-electricity conversion part are arranged in a line on a semiconductor substrate 3, and two CCDs 5 are arranged in parallel with the photodiode array. Respective photodiodes 4 are connected to the charge transfer part of the CCD 5 via transfer gates 6 and signal charges stored in the photodiodes 4 are transferred to the CCD 5 by the ON operation of the transfer gates 6. In addition, output amplifiers 7 are provided at the ends of the CCDs 5 and signal charges transferred through the CCDs 5 are amplified in the output amplifiers 7 and output from the solid-state imaging element 1. A charge input means 2 is provided between the initial stages of the CCDs 5, whereby charges, other than the charges from the photodiodes, are injected into the CCDs 5 from outside. This charge input means 2 electrically supplies charges to the CCDs 5 at the time other than the imaging mode thereby to check and calibrate the CCDs 5 and the output amplifiers 7 or to test the respective transfer electrodes constituting the CCD 5 in the production process for the CCD 5.

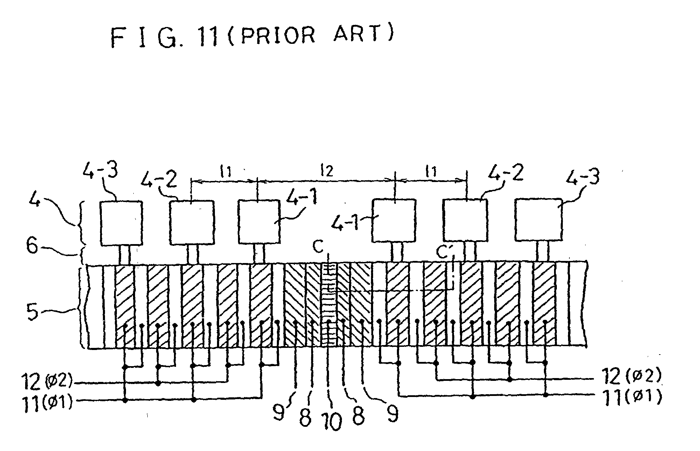

Figure 11 is a plan view showing the structure of the charge input means 2 in detail. In figure 11, reference numeral 10 designates a charge input terminal. Charge input controlling gates 8 and 9, which control the quantity of charges input from the charge input terminal 10, are provided at both sides of the charge input terminal 10. Reference numerals 11 and 12 designate transfer electrodes of the CCD 5.

Operation at the time of charge input mode will be described hereinafter.

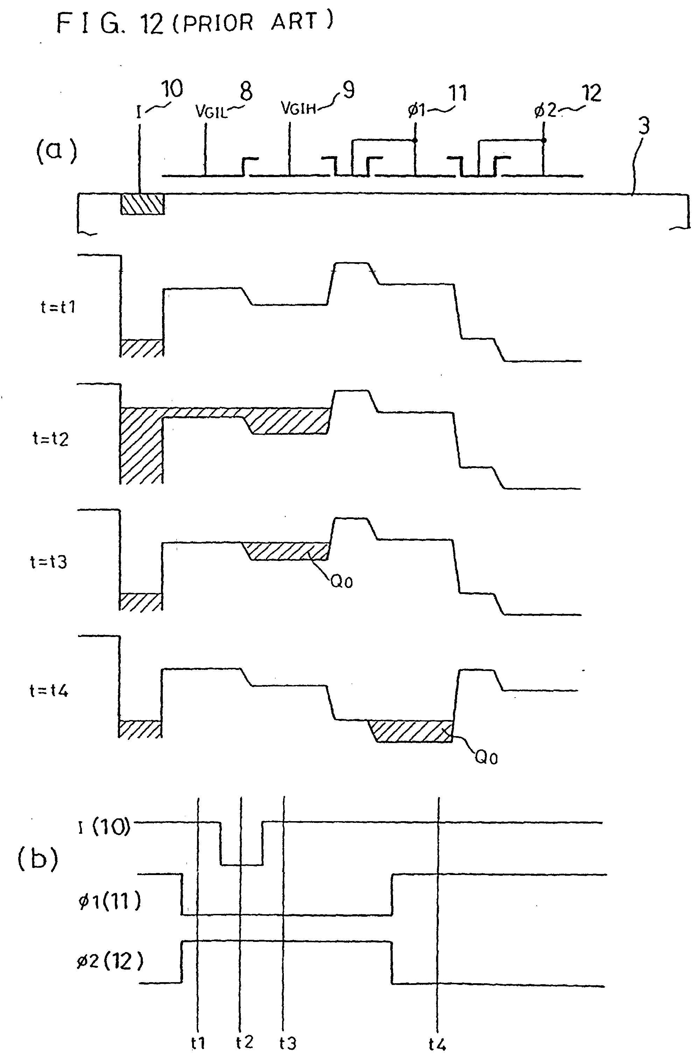

Figure 12(a) is a diagram schematically showing a cross-section taken along a line C - C' of figure 11 and the potential at times t₁ to t₄ at the charge input mode. Figure 12(b) schematically shows waveforms of signals that are applied to the respective terminals.

Clock pulses I, φ1, and φ2 are applied to the charge input terminal 10, and signal input terminals of the transfer electrodes 11 and 12, respectively, and dc voltages V_{GIL} and V_{GIH} are applied to the signal input terminals of the charge input controlling gates 8 and 9, respectively.

First, at time t₁, the charge input terminal 10 and the transfer electrode 12 are at "H" level while the transfer electrode 11 is at "L" level.

At time t₂, the input signal I of the charge input terminal 10 becomes "L" level and charges are transferred from the charge input terminal 10 to the potential well beneath the input controlling gates 8 and 9. At time t₃, the charge input terminal 10 again becomes "H" level and the input charges Q₀ are stored in the potential well beneath the input controlling gate 9.

At time t₄, φ1 is at "H" level while φ2 is at "L" level and then the transfer electrode 11 becomes "H" level and the transfer electrode 12 becomes "L" level, whereby measured charges Q₀ are transferred to the potential well beneath the CCD transfer electrode.

Next, operation at the time of imaging mode will be described hereinafter.

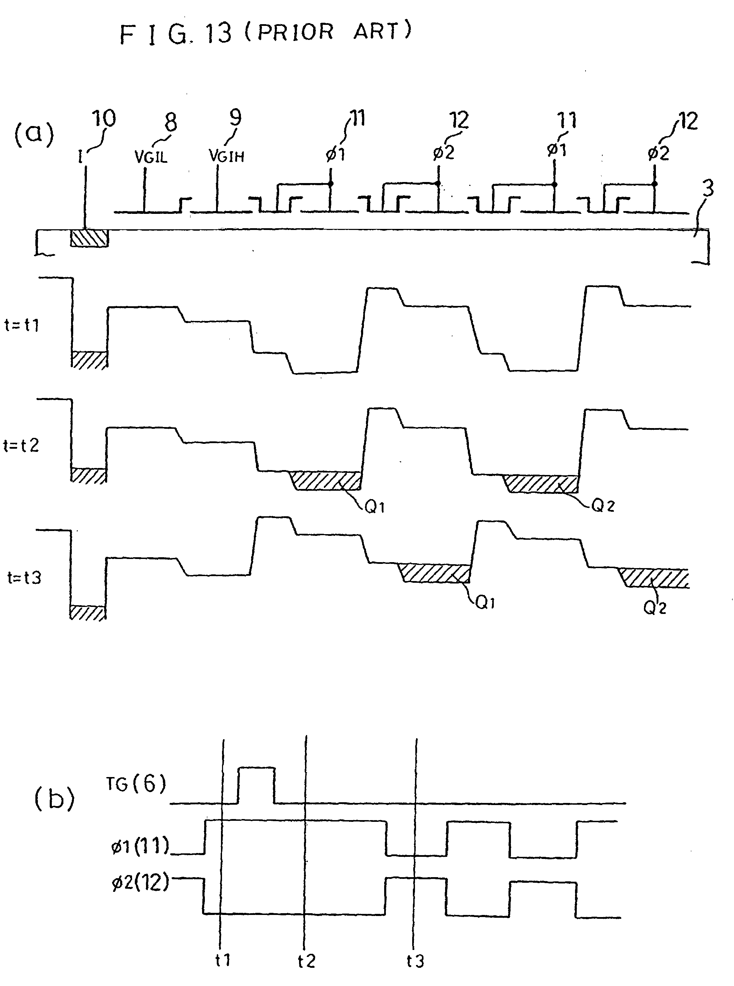

Figure 13(a) is a diagram schematically showing a cross-section taken along a line C-C' of figure 11 and the potential at times t₁ to t₃ at the imaging mode. Figure 13(b) schematically shows waveforms of signals applied to the respective terminals.

Clock pulses φ1 and φ2 are applied to the signal input terminals of the transfer electrodes 11 and 12, respectively, and dc voltages V_{GIL} and V_{GIH} are applied to the signal input terminals of the charge input controlling gates 8 and 9, respectively.

Between times t₁ and t₂, the transfer gate (TG) 6 is opened and the signal charges Q₁ and Q₂ detected respectively in the light receiving elements 4-1 and 4-2 are transferred to the potential wells beneath the corresponding transfer electrodes 11.

At time t₃, the signal φ1 of the transfer electrode 11 is set to "H" level and the signal φ2 of the transfer electrode 12 is set to "L" level, whereby the signal charges Q₁ and Q₂ are transferred to the potential wells beneath the transfer electrodes 12 at the next stage. Thereafter, by repeating this operation, the signal charges are synchronized with the clock pulses and successively transferred.

Since the charge input part 2 of the prior art linear image sensor is constituted as described above, the array pitch of the light receiving element 4 at the charge transfer part 2 is unfavorably larger than elsewhere.

More specifically, in a case where the width of the transfer electrodes 11 and 12 is 8 µm and the interval between the adjacent light receiving elements 4-1 and 4-2 (in figure 11, ℓ1) is 16 µm the interval between the light receiving elements 4-1 (in figure. 11, ℓ2) is required to be 31 µm when the width of the charge input terminal is 4 µm and the widths of the charge input controlling gates 8 and 9 are 3 µm and 4 µm respectively.

When the space of the charge input part 2 is large and the array pitch of the light receiving element 4 corresponding to this part is large, resolution is sharply lowered at the charge input part 2, so that a uniform resolution over the chip cannot be obtained.

US-A-4 647 977 discloses a solid state imaging device comprising a pair of horizontal charge coupled devices (CCD's) arranged in series with a multiplex output section arranged therebetween. Each element of a linear array of light-receiving elements is coupled to a respective stage of the horizontal CCD's via vertical CCD shift registers. These latter have a fanned arrangement so that a uniform element spacing is possible for the linear array. Other features of this disclosure are recited in the preamble of the main claim appended hereto.

The solid state image device according to the present invention is characterised in that the charge input means comprises a first electrode, second electrode adjacent to, and downstream of, the first electrode and a and a third electrode adjacent to, and downstream of said second electrode;
a first one of the light receiving elements is coupled to a region under the third electrode which region is part of the initial stage of the first charge-coupled device; and
supply means is arranged to supply a first dc voltage to the first electrode and a second dc voltage to the second electrode during a charge input mode to control the quantity of charges input from the charge input source and during an image read-out mode, and the supply means is arranged to supply a clock signal to operate the third electrode as a third charge input controlling gate during the charge input mode, and a clock signal synchronised with one of the clock pulses during the image read-out mode.

In this structure, by applying a clock pulse to the third electrode continually, the third electrode serves as an electrode for transferring the measured charges in the charge input mode while it serves as an initial stage transfer electrode in the operation mode. Thus, operations at both modes can be performed without changing the array pitch of the light receiving elements at the charge input part. In addition, a high performance bias supply can be used for the first and second electrodes at the charge input mode.

In the accompanying drawings:-
Figure 1 a plan view showing an input part of a one-dimensional solid-state imaging device, described by way of background;
Figure 2(a) is a diagram showing a cross-section taken along a line A-A' of figure 1 and the potential at the time of charge input mode and figure 2(b) is a diagram schematically showing waveforms of signals applied to the respective terminals;
Figure 3(a) is a diagram showing a cross-section taken along a line A-A' of figure 1 and the potential at the time of imaging mode and figure 3(b) is a diagram schematically showing waveforms of signals applied to the respective terminals;
Figures 4(a) and 4(b) are plan views showing an input part of a two-dimensional solid-state imaging device;
Figure 5 is a plan view showing an alternative to the two-dimensional solid-state imaging device of Figures 4(a) and 4(b);
Figure 6 is a plan view showing an input part of a one-dimensional solid-state imaging device in accordance with an embodiment of the present invention;
Figure 7(a) is a diagram showing a cross-section taken along a line B-B' of figure 6 and the potential at the time of charge input mode and figure 7(b) is a diagram schematically showing waveforms of signals applied to the respective terminals;
Figure 8(a) is a diagram showing a cross-section taken along a line B-B' of figure 6 and the potential at the time of imaging mode and figure 8(b) is a diagram schematically showing waveforms of signals applied to the respective terminals;
Figures 9(a) and 9(b) are plan views showing an input part of a two-dimensional solid-state imaging device in accordance with this embodiment of the present invention;
Figure 10 is a plan view showing a one-dimensional solid-state imaging device in accordance with unpublished prior art;
Figure 11 is a plan view showing a charge input part of the device shown in figure 10;
Figure 12(a) is a diagram showing a cross-section taken along a line C-C' of figure 11 and the potential at the time of charge input mode and figure 12(b) is a diagram schematically showing waveforms of signals applied to the respective terminals; and
Figure 13(a) is a diagram showing a cross-section taken along a line C-C' of figure 11 and the potential at the time of imaging mode and figure 13(b) is a diagram schematically showing waveforms of signals applied to the respective terminals.

Following a description of a background example, an embodiment of the present invention will be described in detail hereinbelow with reference to the following drawings:

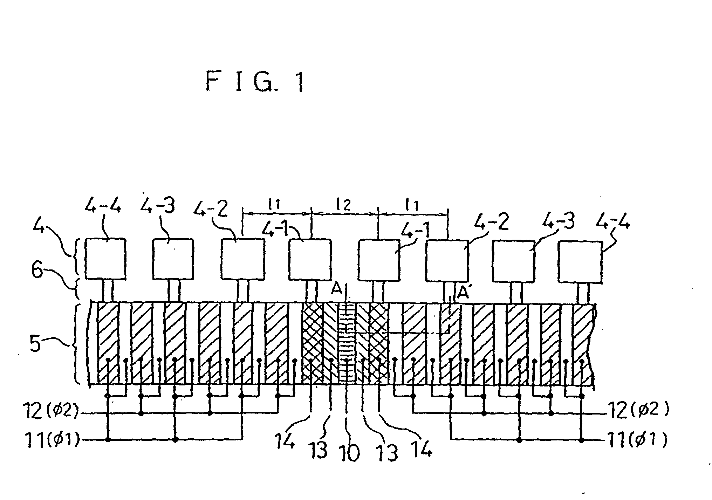

Figure 1 is a plan view schematically showing a structure of a solid-state imaging device , as a background example, in which a charge input means is provided in the centre of the. structure and two CCDs are serially arranged with the charge input means therebetween. In figure 1, a light-to-electricity conversion part 4 is constituted by a plurality of light receiving elements 4-1, 4-2, 4-3, 4-4 ... . Signal charges detected in the light-to-electricity conversion part 4 are transferred to the CCDs 5 via the transfer gates 6 by the ON operation of the transfer gates 6. Reference numerals 11 and 12 designate transfer electrodes of the CCDs 5 and numerals φ1 and φ2 are input signals applied to the transfer gates 11 and 12. Reference numeral 10 designates an electrode input terminal for electrically injecting charges into the CCDs 5 from outside. First charge input. controlling gates 13 are provided in contact with the charge input terminal 10 and control the charges input from the charge input terminal 10. Common gates 14 are provided in contact with the first charge input controlling gates 13 and serve both as second charge input controlling gates and initial stage transfer electrodes. The common gates 14 serve as the second input controlling gates at the time of charge input mode and as the transfer gates like the transfer electrodes 11 at the time of imaging mode.

Operation at the charge input mode will be described hereinafter.

As described above, at the charge input mode, the common gates 14 serve as the second charge input controlling gates with the first charge input controlling gates 13 and they function in the same way as the charge input controlling gates 8 and 9 of the prior art device.

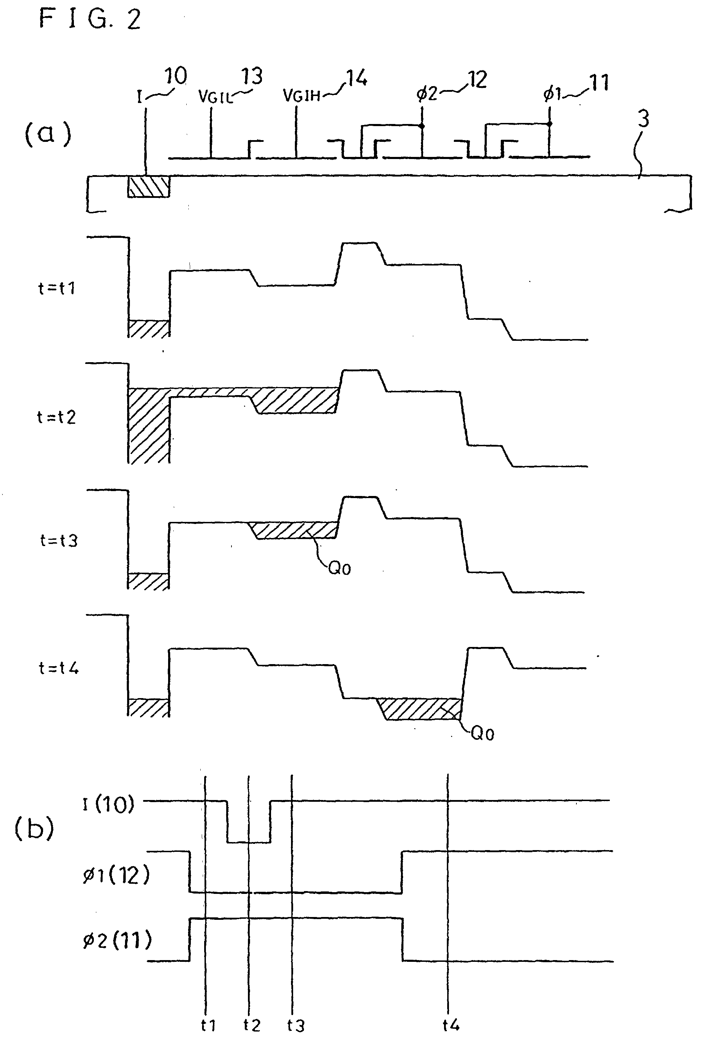

Figure 2(a) shows a cross-section taken along a line A-A' of figure 1 and the potential at times t₁ to t₄. Figure 2(b) schematically shows waveforms of signals applied to the respective terminals.

Clock pulses I, φ1 and φ2 are applied to the charge input terminal 10 and the transfer electrodes 11 and 12, respectively, while dc voltages V_{GIL} and V_{GIH} are applied to the first charge input controlling gate 13 and the common gate 14, respectively. The quantity of the input charge is measured by the difference in voltages applied to the gates 13 and 14 and controlled to be a desired value.

Between times t₁ and t₂, charges are transferred from the charge input terminal 10 to the potential well beneath the input controlling gate 13 and the common gate 14. At time t₃, the charge input terminal 10 becomes "H" level again and the measured input charges Q₀ are stored in the potential well beneath the common gate 14.

At time t₄, the transfer electrode 12 becomes "H" level and the charges Q₀ are transferred to the potential well beneath the CCD transfer electrode 12.

Thus, the charge input operation can be performed in the same way as the prior art device.

Operation at the imaging mode will be described hereinafter.

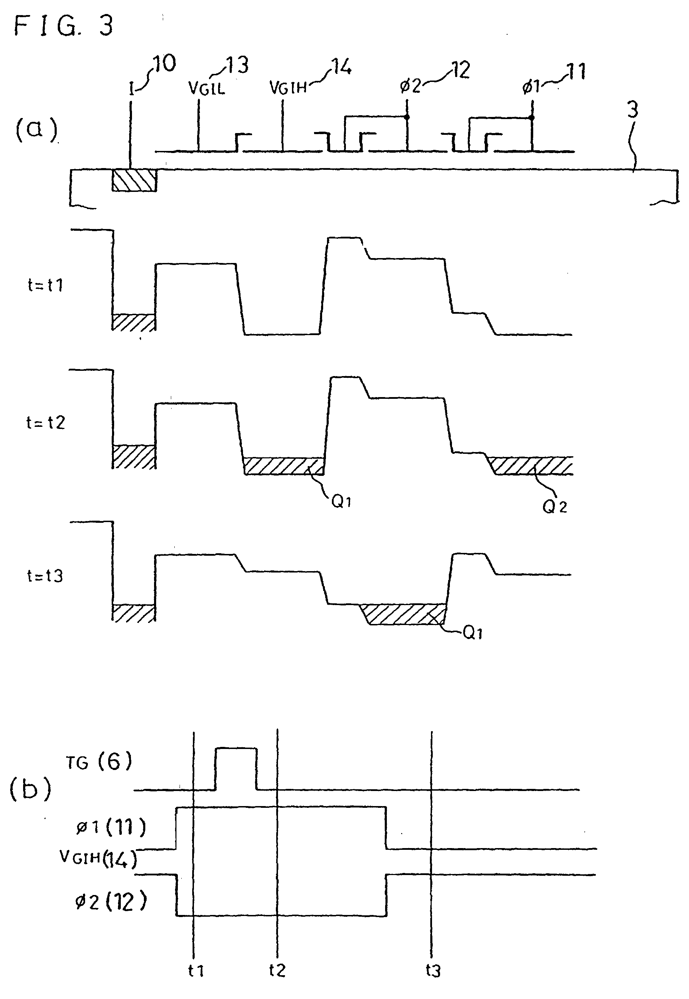

Figure 3(a) shows a cross-section taken along a line A-A' of figure 1 and the potential at times t₁ to t₃. Figure 3(b) schematically shows waveforms of signals applied to the respective terminals.

A clock pulse having the same phase as that applied to the transfer electrode 11 is applied to the common gate 14 and a dc voltage is applied to the charge input controlling gate 13.

Between times t₁ and t₂, the transfer gates TG 6 are opened and signal charges Q₁ and Q₂ stored in the light receiving elements 4-1 and 4-2, respectively, are transferred to the potential wells beneath the common . electrode 14 and the transfer electrode 11, respectively. Thereafter, the transfer electrode 11 and the common electrode 14 are set to "L" level and the transfer electrode 12 is set to "H" level by applying clock pulses and then the signal charges Q₁ beneath the common electrode 14 is transferred to the potential well beneath the transfer electrode 12 and the charges Q₂ beneath the transfer electrode 11 are transferred to the potential well beneath the next stage transfer electrode. In this way, signal charges synchronized with the clock pulses are successively transferred like the prior art image sensor.

In this background example, since the electrode 14 serves both as the second electrode for controlling the quantity of input charge and the initial stage transfer electrode for transferring signal charges, the array pitch of the light receiving elements at the charge input part is as follows with employing the conventional design basis as it is.

In case where the width of the transfer gates 11 and 12 is 8 µm and the interval ℓ1 between adjacent light receiving elements other than those at the charge input part is 16 µm like the prior art device, by setting the width of the charge input terminal 10 to 4 µm and the widths of the charge input controlling gate 13 and the common gate 14 to 3.5 µm and 5 µm respectively, the interval ℓ2 between the light receiving elements 4-1 at the charge input part 2 can also be 16 µm.

Accordingly, in this example, the space of the charge input part 2 can be reduced without changing the scale of the electrode input terminal and the charge input controlling gate, and the array pitch of the light receiving elements corresponding to the charge input part can be equal to the array pitch of the light receiving elements at the other parts.

As described above, the charge input controlling electrode and the transfer electrode are constituted by the same electrode 14. A dc voltage is applied to the electrode 14 at the time of charge input mode so that it may serve as the second charge input controlling electrode and a clock pulse is applied thereto at the time of imaging mode so that it may serve as the transfer electrode. Therefore, the space of the charge input part 2 can be reduced and the array pitch of the light receiving elements corresponding to the charge input part can be equal to the array pitch of the light receiving elements corresponding to the other parts, whereby the pattern design can be simplified. In addition, no reduction in resolution occurs at the charge input part and a uniform resolution can be obtained in the chip.

While a one-dimensional solid-state imaging device has just been described, the same principles as above can be applied to a two-dimensional solid-state imaging device.

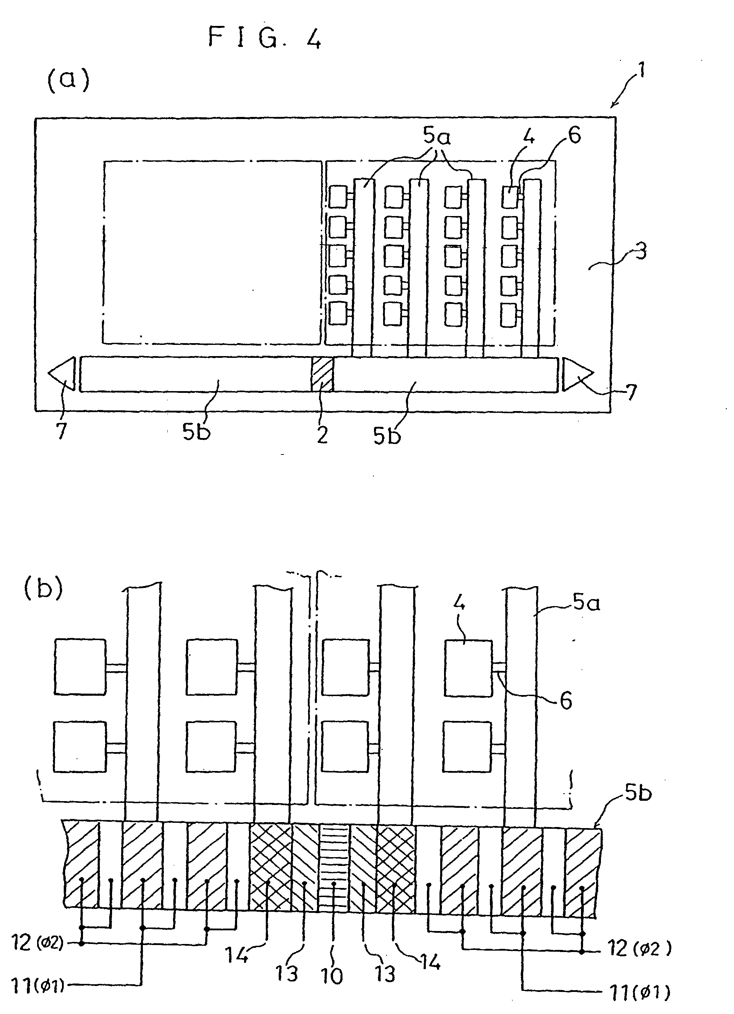

Figure 4(a) is a plan view showing a two-dimensional solid-state imaging device in which the charge input part 2 as described above is applied to a horizontal CCD, and figure 4(b) is a plan view showing the charge input part 2 and its vicinity in detail. In these figures, the same references as those shown in figure 1 designate the same parts, and reference numerals 5a and 5b designate vertical CCDs and horizontal CCDs, respectively. The structure of the charge input part 2 is similar to that shown in figure 1 according to the first embodiment except that the common gates 14 are connected with the output terminals of the vertical CCDs 5a.

In this structure, the two-dimensional solid-state imaging device is divided in the middle and signal charges detected in the light receiving elements 4 are transferred by the vertical CCDs 5a through the transfer gates 6. Signal charges transferred from the vertical CCDs 5a are read out simultaneously by the two horizontal CCDs 5b.

Also in this structure, the common gates 14 are provided in the charge input part 2 between the horizontal CCDs 5b, and a dc voltage is applied to the common gates 14 at the time of charge input mode so that they may serve as charge input controlling gates and a clock pulse synchronized with the transfer electrode 11 is applied thereto at the time of imaging mode so that they may serve as transfer electrodes of the CCDs 5. Thus, similarly as in the example of Figures 1 to 3, the space of the charge input part 2 can be reduced and the array pitch of the light receiving elements corresponding to this part can be equal to the array pitch of light receiving elements corresponding to the transfer.electrode parts. As a result, a reduction in resolution, which is caused by the provision of the charge input part, can be prevented.

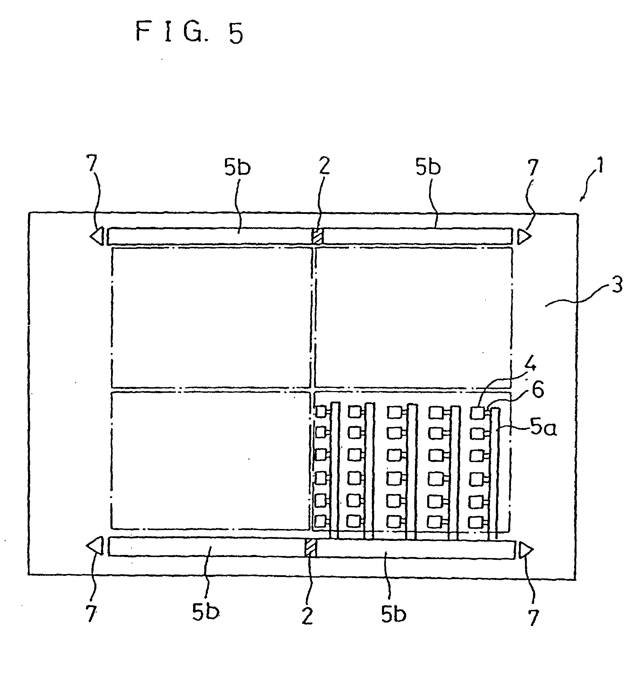

Figure 5 is a plan view showing another structure of a two-dimensional solid-state imaging device, in which two two-dimensional solid-state imaging devices shown in figure 2 are symmetrically arranged on the semiconductor substrate 3. Also in this structure, when the charge input part 2 as just described is employed, all the light receiving elements 4 can be arranged at the same pitch, whereby the pattern production can be simplified and an uniform resolution can be obtained in the chip.

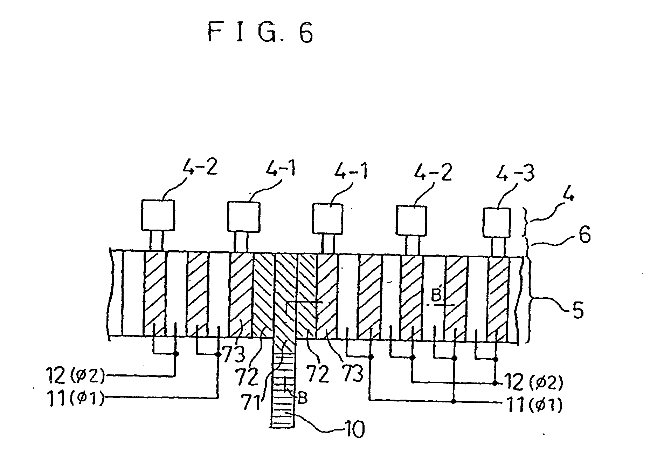

Figure 6 is a plan view showing a solid-state imaging device in accordance with an embodiment of the present invention. In figure 6, the same reference numerals as those in figure 1 designate the same parts. A first charge input controlling gate 71 is serially connected with the charge input terminal 10. Second charge input controlling gates 72 are provided in contact with the first gate 71. The first and second gates 71 and 72 control the quantity of charges input from the charge input terminal 10. Common gates 73 are provided in contact with the second gates 72. These common gates 73 serve as third charge input controlling gates for transferring the charges measured in the first and second charge input controlling gates 71 and 72 at the time of charge input mode and serve as initial stage transfer electrodes for storing the signal charges from pixels for a time and thereafter transferring the same.

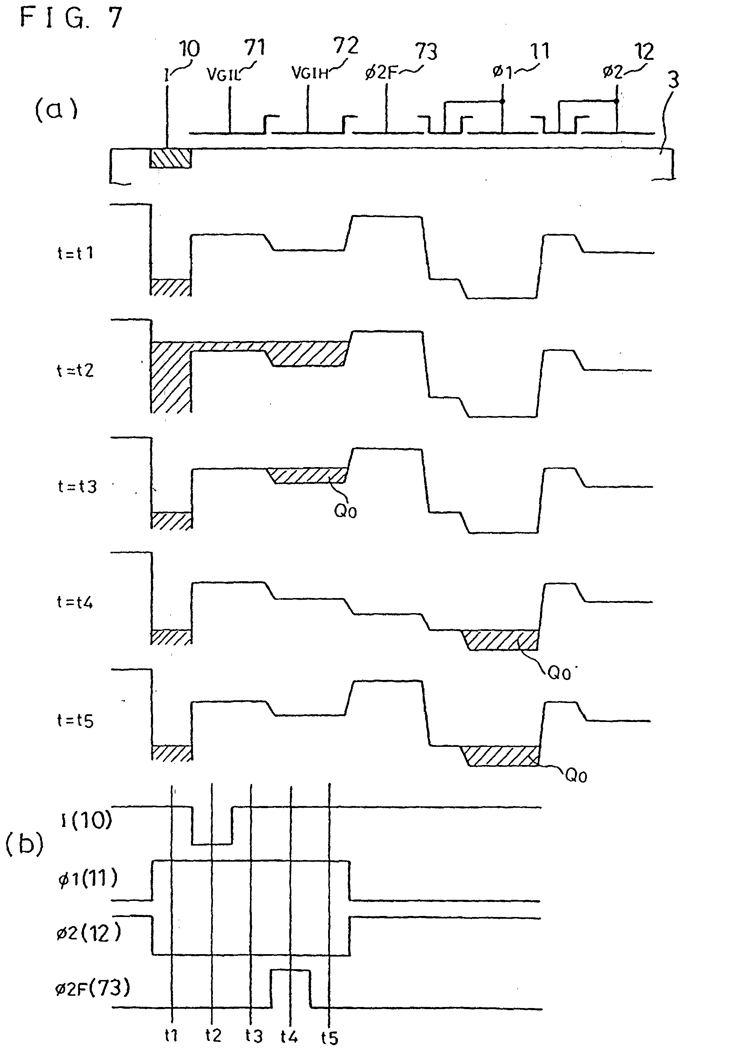

Operation in the charge input mode will be described. Figure 7(a) is a diagram showing a cross-section taken along a line B-B' of figure 6 and the potential at times t₁ to t₅. Figure 7(b) shows waveforms of signals applied to the respective terminals.

Clock pulses I, φ1, φ2, φ2F are applied to the charge input terminal 10, the transfer electrodes 11 and 12, and the common gate 73, respectively, while dc voltages V_{GIL} and V_{GIH} are applied to the charge input controlling gates 71 and 72.

At time t₁, signals of "H" level are applied to the charge input terminal 10 and the transfer electrode 11 while signals of "L" level are applied to the transfer electrode 12 and the signal input terminal of the common gate 73.

At time t₂, the level of the charge input terminal 10 is lowered and charges are. transferred from the charge input terminal 10 to the potential well beneath the input controlling gates 71 and 72.

At time t₃, the charge input terminal 10 becomes "H" level again and the measured input charges Q₀ are stored only in the potential well beneath the input controlling gate 72.

At time t₄, the common gate 73 becomes "H" level and the charges Q₀ are transferred to the potential well beneath the CCD transfer electrode 11.

Operation in the imaging mode will be described.

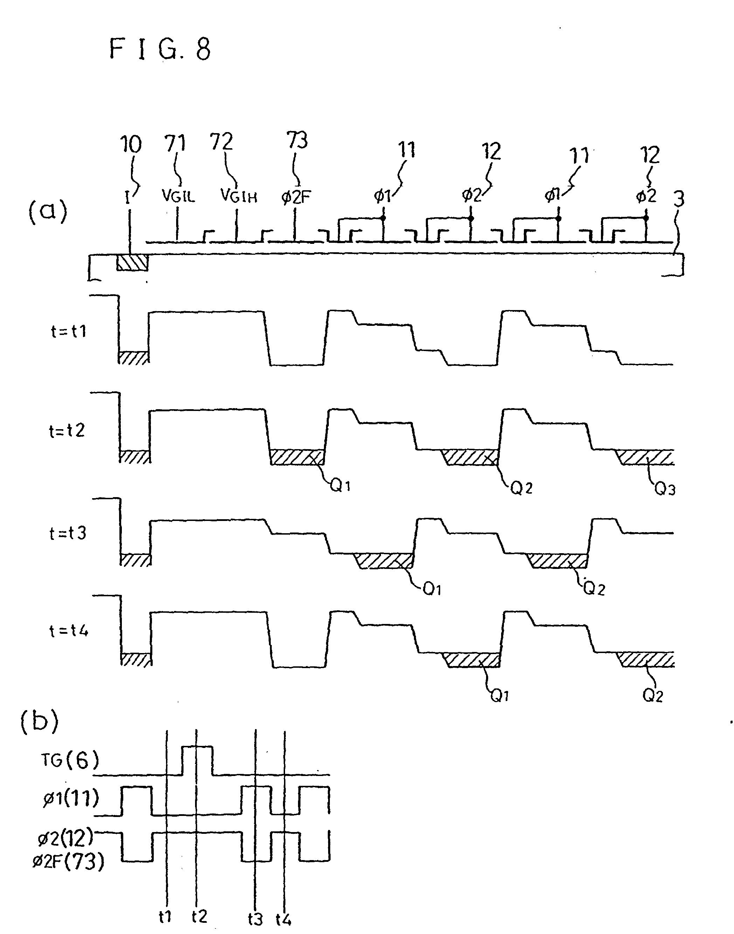

Figure 8(a) is a diagram showing a cross-section taken along a line B-B' of figure 6 and the potential at times t₁ to t₄. Figure 8(b) shows waveforms of signals applied to the respective terminals.

A clock pulse having the same phase as that for the transfer electrode 12 is applied to the common gate 73 and dc voltages are applied to the charge input controlling gates 71 and 72.

Between times t₁ and t₂, the transfer gates TG 6 are opened and the signal charges Q₁ and Q₂ stored in the light receiving elements 4-1 and 4-2 are transferred to the potential wells beneath the common electrode 73 and the transfer electrode 12, respectively.

At time t₃, the transfer electrode 12 and the common electrode 73 are set to "L" level and the transfer electrodes 11 are set to "H" level by applying clock pulses, whereby the signal charges Q₁ beneath the common electrode 73 are transferred to the potential well beneath the transfer electrode 11 and the signal charges Q₂ beneath the the transfer electrode 12 are transferred to the potential well beneath the transfer electrode 11 at the next stage.

At time t₄, the transfer electrodes 12 and the common electrode 73 become "H" level and the transfer electrodes 11 become "L" level, and the signal charges Q₁ and Q₂ beneath the transfer electrodes 11 are transferred to the potential wells beneath the transfer electrodes 12 at the next stage.

Thus, signal charges are synchronized with clock pulses and then transferred successively, whereby signals detected in the light receiving elements 4 are read out. In this embodiment, since the charge input terminal 10 is provided outside the CCDs 5, the space of the charge input part 2 can be equal to that of the above background example although the common gates 73 are added.

In this embodiment, the array pitch of the light receiving elements at the charge input part is as follows.

In case where the width of the transfer electrodes 11 and 12 is 8 µm and the interval between adjacent light receiving elements other than those at the charge input part is 16 µm like the unpublished prior art device, by setting the width of the charge input terminal 10 to 4 µm the widths of the charge input controlling gates 71 and 72 to 3.5 microns and 5 µm respectively, and the width of the common gate 73 to 5 µm, the interval between the light receiving elements 4-1 corresponding to the charge input part is 16 µm, as in the above background example. Thus, the array pitch of the light receiving elements corresponding to the charge input part can be equal to that of the light receiving elements corresponding to other parts. Also in this embodiment, the CCD is provided with the charge input means with keeping the array pitch and the resolution uniform in the chip.

Now, consideration is given of the common gate. In the background example, in order to make the common gate 14 serve as the initial stage transfer electrode at the time of imaging mode and serve as the second charge input controlling gate at the time of charge input mode, it is necessary to apply a clock pulse to the common gate 14 at the imaging mode and a dc voltage at the charge input mode. Therefore, a clock pulse supply is always connected to the common gate 14 and when the dc voltage is applied to the common gate 14, a constant bias is generated using this clock pulse supply. Therefore, a capacitor for stabilizing the potential of the common gate 14 at the charge input time cannot be provided and a bias supply with high precision cannot be expected.

In this embodiment, however, the third charge input controlling gate is added to the structure of the charge input part 2 and the common gate 73 is driven only by clock pulse the charge input mode and the operating mode. Therefore, dc voltage only is always applied to the first and second charge input controlling gates 71 and 72, so that the charge input controlling gates 71 and 72 can be provided with a capacitor for stabilizing the potential thereof, resulting in a bias supply with high precision.

That is, in this embodiment, the switching of signals at the common gate is not required and a stable bias supply can be formed in the charge input controlling gate in addition to the effects of the background example.

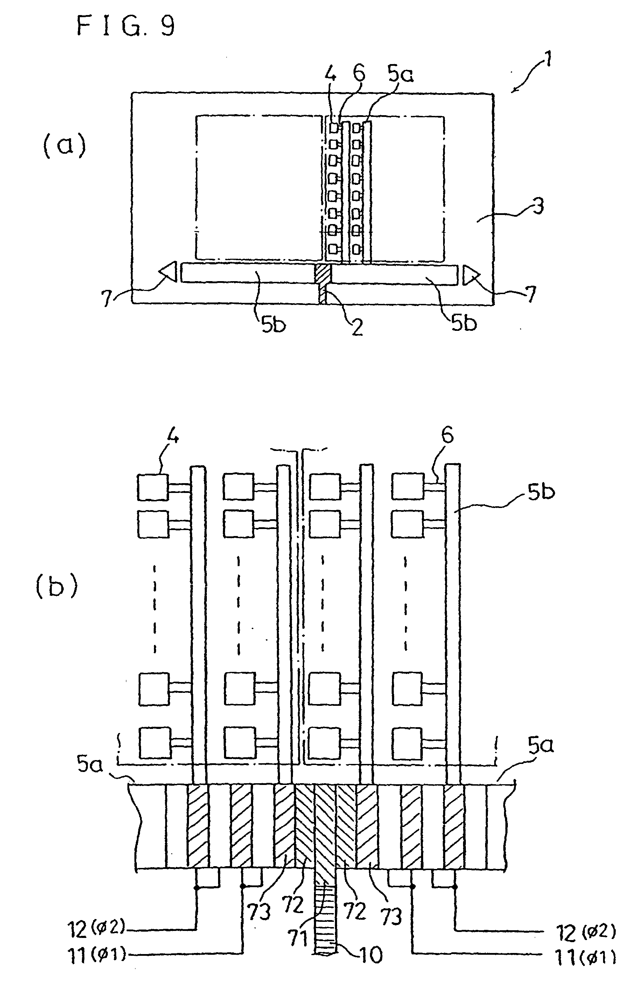

While only a one-dimensional solid-state imaging device has been described, the present invention can be applied to a two-dimensional solid-state imaging device. Figure 9(a) is a plan view showing a two-dimensional solid-state imaging device provided with the charge input part 2 of the embodiment and figure 9(b) is a plan view showing the charge input part 2 in detail. Also in this case, the charge input means 2 can be provided at the initial stage of the horizontal CCD 5b using a normal design basis without changing the array pitch of the light receiving elements.

In the foregoing embodiment, a charge input means comprising a charge input source and first to third electrodes for controlling the quantity of input charges is provided at the initial stage of the charge coupled device. The first electrode is arranged in contact with the charge input source and the second electrode is arranged in contact with the first electrode. The third electrode is arranged in contact with the second electrode and connected to the light receiving element via the transfer gate or another charge coupled device. In this structure, by applying a clock pulse to the third electrode continually, the third electrode serves as an electrode for transferring the measured charges at the time of charge input mode while it serves as an initial stage transfer electrode at the time of imaging mode. As a result, a high performance solid-state imaging device that can test the charge coupled device electrically during its operation while keeping the resolution uniform without changing the array pitch of the light receiving elements at the charge input part.

## Claims

1. A solid state imaging device comprising:
a first charge-coupled device (5) having transfer electrodes (11, 12);
a first plurality of light receiving elements (4-1 to 4-4), each coupled through a transfer gate (6) to a respective stage of said first charge-coupled device (5),
charge input means (2) for controlling a quantity of charge input from a charge input source (10) to an initial stage of said first charge-coupled device; and
clocking means arranged to supply clock pulses (φ₁, φ₂) to the transfer electrodes (11,12) of said first charge-coupled device to transfer charges (Q₀,Q₁,Q₂) along said first charge-coupled device,
**characterised in that**:
said charge input means (2) comprises a first electrode (71), a second electrode (72) adjacent to, and downstream of, said first electrode (71) and a third electrode (73) adjacent to, and downstream of said second electrode (72);
a first one (4-1) of said light receiving elements (4-1) is coupled to a region under said third electrode (73) which region is part of the initial stage of said first charge-coupled device (5); and
supply means is arranged to supply a first dc voltage (V_{GIL}) to the first electrode (71) and a second dc voltage (V_{GIH}) to the second electrode (72) during a charge input mode to control the quantity of charges input from the charge input source (10) and during an image read-out mode, and the supply means is arranged to supply a clock signal to operate the third electrode (73) as a third charge input controlling gate during the charge input mode, and a clock signal synchronised with one of said clock pulses (φ₁, φ₂) during the image read-out mode.

2. A solid state imaging device according to claim 1 including:
a second charge-coupled device (5) arranged in series with said first charge-coupled device (5) with said charge input means (2) therebetween; and
a second plurality of light receiving elements (4-1 to 4-4) each coupled through a transfer gate (6) to a respective stage of said second charge-coupled device; wherein
the transfer electrodes (11,12) of said second charge-coupled device are connected to said clocking means to receive said clock pulses (φ₁,φ₂);
said charge input means (2) includes another first electrode (71), another second electrode (72) adjacent to and downstream of said another first electrode (71) and another third electrode (73) adjacent to and downstream of said second electrode (72) in the transfer direction of said second charge-coupled device away from said input means (2);
a first one (4-1) of the light receiving elements (4-1 to 4-4) of said second plurality is coupled to a region under said another third electrode (73), which region is part of the initial stage of said second charge-coupled device (5); and
said another first and second electrodes (71,72) are connected to said supply means likewise to receive said first and second dc voltages (V_{GIL},V_{GIH}) respectively during charge input and image read-out modes and said another third electrode (73) is connected to said supply means likewise to receive a signal to operate said another third electrode (73) as a third charge input controlling gate during the charge input mode, and to receive a clock signal synchronised with one of said clock pulses (φ₁,φ₂) during the image read-out mode.

3. A solid state imaging device according to claim 2, wherein the spacings (ℓ₁) of said light receiving elements of each first and second plurality and the spacing (ℓ₂) between said first one (4-1) of said first plurality and said first one (4-1) of said second plurality are equal.

4. A solid state imaging device according to any preceding claim, wherein respective third charge-coupled devices (5a) are interposed between respective stages of said first, or of said first and second, charge-coupled devices (5b) and respective ones of said light receiving elements (4) with respective transfer gates (6).

## Revendications

1. Dispositif d'imagerie à l'état solide comprenant :
un premier dispositif à couplage de charges (5) comportant des électrodes de transfert (11, 12) ;
une première pluralité d'éléments de réception de lumière (4-1 à 4-4), chacun couplé par une porte de transfert (6) à un étage respectif dudit dispositif à couplage de charges (5),
un moyen d'entrée de charge (2) peur commander une quantité de charge entrée à partir d'une source d'entrée de charge (10) à un étage initial dudit premier dispositif à couplage de charges ; et
un moyen d'horloge agencé pour fournir des impulsions d'horloge (φ₁, φ₂) aux électrodes de transfert (11, 12) dudit premier dispositif à couplage de charges peur transférer des charges (Q₀, Q₁, Q₂) le long dudit premier dispositif à couplage de charges,
**caractérisé en ce que** :
ledit moyen d'entrée de charge (2) comprend une première électrode (71), une deuxième électrode (72) adjacente à et en aval de ladite première électrode (71) ainsi qu'une troisième électrode (73) adjacente à et en aval de ladite deuxième électrode (72) ;
un premier (4-1) desdits éléments de réception de lumière (4-1) est couplé à une région sous ladite troisième électrode (73), cette région faisant partie de l'étage initial dudit premier dispositif à couplage de charges (5) ; et
un moyen d'amenée est agencé pour fournir une première tension continue (V_{GIL}) à la première électrode (71) et une deuxième tension continue (V_{GIH}) à la deuxième électrode (72) pendant un mode d'entrée de charge pour commander la quantité des charges entrée depuis la source d'entrée de charge (10) et pendant un mode de lecture d'images, et le moyen d'amenée est agencé pour fournir un signal d'horloge pour faire fonctionner la troisième électrode (73) comme une troisième porte de commande d'entrée de charge en mode d'entrée de charge, et un signal d'horloge synchronisé avec l'une desdites d'impulsions d'horloge (φ₁, φ₂) pendant le mode de lecture d'images.

2. Dispositif d'imagerie à l'état solide selon la revendication 1, comportant :
un deuxième dispositif à couplage de charges (5) agencé en série avec ledit premier dispositif à couplage de charges (5), avec ledit moyen d'entrée de charge (2) entre ceux-ci ; et
une deuxième pluralité d'éléments de réception de lumière (4-1 à 4-4) chacun couplé par une porte de transfert (6) à un étage respectif dudit deuxième dispositif à couplage de charges ; où
les électrodes de transfert (11, 12) dudit deuxième dispositif à couplage de charges sont reliées audit moyen d'horloge pour recevoir lesdites impulsions d'horloge (φ₁, φ₂) ;
ledit moyen d'entrée de charges (2) comporte une autre première électrode (71), une autre deuxième électrode (72) adjacente à et en aval de ladite autre première électrode (71) et une autre troisième électrode (73) adjacente à et en aval de ladite deuxième électrode (72) dans la direction de transfert dudit deuxième dispositif à couplage de charges au loin dudit moyen d'entrée (2) ;
un premier (4-1) des éléments de réception de lumière (4-1 à 4-4) de ladite seconde pluralité est couplé à une région sous ladite autre troisième électrode (73), cette région faisant partie de l'étage initial dudit deuxième dispositif à couplage de charges (5) ; et
les autres première et deuxième électrodes (71, 72) précitées sont reliées audit moyen d'alimentation de la même manière pour recevoir lesdites première et seconde tensions continues (V_{GIL}, V_{GIH}) respectivement en modes d'entrée de charge et de lecture d'images, et l'autre troisième électrode (73) précitée est reliée audit moyen d'amenée de la même manière pour recevoir un signal pour faire fonctionner l'autre troisième électrode (73) précitée comme une troisième porte de commande d'entrée de charge en mode d'entrée de charge, et pour recevoir un signal d'horloge synchronisé avec l'une desdites impulsions d'horloge (φ₁, φ₂) en mode de lecture d'images.

3. Dispositif d'imagerie à l'état solide selon la revendication 2, où les espacements (ℓ₁) desdits éléments de réception de lumière de chacune des première et seconde pluralités et l'espacement (ℓ₂) entre ladite première (4-1) de ladite première pluralité et ladite première (4-1) de ladite seconde pluralité sont égaux.

4. Dispositif d'imagerie à l'état solide selon l'une des revendications précédentes, où des troisièmes dispositifs à couplage de charges respectifs (5a) sont interposés entre des étages respectifs dudit premier, ou dudit premier et deuxième dispositifs à couplage de charges (5b) et des éléments respectifs parmi lesdits éléments de réception de lumière (4), avec des portes de transfert respectives (6).

## Patentansprüche

1. Halbleiter-Bildaufnahmevorrichtung, welche aufweist:
ein erstes ladungsgekoppeltes Bauelement (5), welches Übertragungselektroden (11,12) aufweist;
eine erste Mehrzahl von Licht empfangenden Elementen (4-1 bis 4-4), von denen jedes durch ein Transfergatter (6) mit einer jeweiligen Stufe des ersten ladungsgekoppelten Bauelements (5) gekoppelt ist;
eine Ladungseingabeeinrichtung (2) zum Steuern einer von einer Ladungseingabequelle (10) zu einer Eingangsstufe des ersten ladungsgekoppelten Bauelements eingegebenen Ladungsmenge; und
eine Taktgebereinrichtung, welche angeordnet ist, um Taktimpulse (φ₁, φ₂) an die Übertragungselektroden (11, 12) des ersten ladungsgekoppelten Bauelements zu liefern, um Ladungen (Q₀, Q₁, Q₂) entlang dem ersten ladungsgekoppelten Bauelement zu übertragen,
***dadurch gekennzeichnet, daß***
die Ladungseingabeeinrichtung (2) eine erste Elektrode (71), eine an die erste Elektrode (71) angrenzende und dieser nachgeschaltete zweite Elektrode (72) und eine an die zweite Elektrode (72) angrenzende und dieser nachgeschaltete dritte Elektrode (73) aufweist;
ein erstes (4-1) der Licht empfangenden Elemente (4-1) mit einer Region unter der dritten Elektrode (73) gekoppelt ist, wobei die Region ein Teil der Eingangsstufe des ersten ladungsgekoppelten Bauelements (5) ist; und
eine Versorgungseinrichtung angeordnet ist, um während einer Ladungseingabebetriebsart, um die von der Ladungseingabequelle (10) eingegebene Ladungsmenge zu steuern, und während einer Bildauslesebetriebsart eine erste Gleichspannung (V_{GIL}) an die erste Elektrode (71) und eine zweite Gleichspannung (V_{GIH}) an die zweite Elektrode (72) zu liefern, und die Versorgungseinrichtung angeordnet ist, um während der Ladungseingabebetriebsart ein Taktsignal, um die dritte Elektrode (73) als ein drittes Ladungseingabesteuergatter zu betreiben, und während der Bildauslesebetriebsart ein mit einem der Taktimpulse (φ₁, φ₂) synchronisiertes Taktsignal zu liefern.

2. Halbleiter-Bildaufnahmevorrichtung nach Anspruch 1, welche umfaßt:
ein zweites ladungsgekopppeltes Bauelement (5), welches in Reihe mit dem ersten ladungsgekoppelten Bauelement (5) mit der Ladungseingabeeinrichtung (2) dazwischen angeordnet ist; und
einer zweiten Mehrzahl von Licht empfangenden Elementen (4-1 bis 4-4), von denen jedes durch ein Transfergatter (6) mit einer jeweiligen Stufe des zweiten ladungsgekoppelten Bauelements gekoppelt ist; wobei
die Übertragungselektroden (11, 12) des zweiten ladungsgekoppelten Bauelements mit der Taktgebereinrichtung verbunden sind, um die Taktimpulse (φ₁, φ₂) zu empfangen;
die Ladungseingabeeinrichtung (2) eine weitere erste Elektrode (71), eine an die weitere erste Elektrode (71) angrenzende und dieser nachgeschaltete weitere zweite Elektrode (72) und eine an die weitere zweite Elektrode (72) angrenzende und dieser nachgeschaltete weitere dritte Elektrode (73) in der Übertragungsrichtung des zweiten ladungsgekoppelten Bauelements von der Eingabeeinrichtung (2) weg aufweist;
ein erstes (4-1) der Licht empfangenden Elemente (4-1 bis 4-4) der zweiten Mehrzahl mit einer Region unter der weiteren dritten Elektrode (73) gekoppelt ist, wobei die Region ein Teil der Eingangsstufe des zweiten ladungsgekoppelten Bauelements (5) ist; und
die weitere erste und zweite Elektrode (71, 72) ebenso mit der Versorgungseinrichtung verbunden sind, um während Ladungseingabe- und Bildauslesebetriebsarten die erste bzw. zweite Gleichspannung (V_{GIL}, V_{GIH}) zu empfangen, und die weitere dritte Elektrode (73) ebenso mit der Versorgungseinrichtung verbunden ist, um während der Ladungseingabebetriebsart ein Signal zu empfangen, um die weitere dritte Elektrode (73) als ein drittes Ladungseingabesteuergatter zu betreiben, und während der Bildauslesebetriebsart ein mit einem der Taktimpulse (φ₁, φ₂) synchronisiertes Taktsignal zu empfangen.

3. Halbleiter-Bildaufnahmevorrichtung nach Anspruch 2, wobei die Abstände (I₁) der Licht empfangenden Elemente der ersten und zweiten Mehrzahl und der Abstand (I₂) zwischen dem ersten (4-1) der ersten Mehrzahl und dem ersten (4-1) der zweiten Mehrzahl gleich sind.

4. Halbleiter-Bildaufnahmevorrichtung nach einem der vorgenannten Ansprüche, wobei jeweilige dritte ladungsgekoppelte Bauelemente (5a) zwischen jeweiligen Stufen der ersten oder der ersten und zweiten ladungsgekoppelten Bauelemente (5b) und jeweiligen der Licht empfangenden Elemente (4) mit jeweiligen Transfergattern (6) angeordnet sind.
